# FASCICULE DE BREVET EUROPEEN

(11) **EP 3 686 942 B1**
(45) Date de publication et mention de la délivrance du brevet: **10.11.2021**
(21) Numéro de dépôt: 20153899.8
(22) Date de dépôt: 27.01.2020
(51) Int. Cl.: H01L 45/00

(54) **PROCÉDÉ DE FABRICATION D'UNE MEMOIRE RESISTIVE A CHANGEMENT DE PHASE**
VERFAHREN ZUR HERSTELLUNGS EINES RESISTIVEN PHASENWECHSELSPEICHERS
METHOD FOR FABRICATING A RESISTIVE PHASE-CHANGE MEMORY

(30) Priorité: 28.01.2019 FR 1900749
(43) Date de publication de la demande: 29.07.2020
(73) Titulaire: Commissariat à l'Energie Atomique et aux Energies Alternatives, 75015 Paris (FR)
(72) Inventeur: NAVARRO, Gabriele, 38054 GRENOBLE CEDEX 9 (FR)
(74) Mandataire: Cabinet Camus Lebkiri

(56) Documents cités:
- US-A1- 2007 034 849
- US-A1- 2009 286 037
- WU Z ET AL: "Controlled recrystallization for low-current RESET programming characteristics of phase-change memory with Ge-doped SbTe", APPLIED PHYSICS LETTERS, vol. 99, no. 14, 143505, 3 octobre 2011 (2011-10-03), XP012153225, ISSN: 0003-6951, DOI: 10.1063/1.3641470
- CHEONG B-K ET AL: "Characteristics of Phase Change Memory Devices based on Ge-doped SbTe and its derivative", EUROPEAN PHASE CHANGE AND OVONIC SYMPOSIUM E*PCOS 2007, ZERMATT, SWITZERLAND , 2007, XP055642181, Extrait de l'Internet: URL:https://www.epcos.org/e-pcos-2007 [extrait le 2019-11-14]

## Description

### DOMAINE TECHNIQUE DE L'INVENTION

Le domaine technique de l'invention est celui des mémoires résistives à changement de phase.

La présente invention concerne un procédé de fabrication d'une mémoire résistive à changement de phase et en particulier d'une mémoire résistive à changement de phase dont le matériau actif est un ternaire composé de germanium Ge, de tellure Te et d'antimoine Sb.

### ARRIERE-PLAN TECHNOLOGIQUE DE L'INVENTION

Grâce à leur capacité à augmenter les performances des ordinateurs tout en réduisant leur consommation, les mémoires de type SCM (pour « Storage Class Memory » ou mémoire à classe de stockage) caractérisées par un temps de programmation faible, inférieur à 10 ns et une grande endurance, de plus de 10⁹ cycles, connaissent un essor important.

Dans ce contexte, les mémoires résistives représentent de très bons candidats pour supporter le développement des mémoires SCM et parmi elles, les mémoires à changement de phase PCM (pour « Phase-Change Memory ») semblent être la technologie de mémoire résistive la plus mûre.

Les mémoires résistives présentent au moins deux états correspondant au passage d'un état fortement résistif à un état faiblement résistif (SET) ou réciproquement (RESET).

Les mémoires PCM classiques comportent deux électrodes et une couche active basée sur un matériau chalcogénure. Le fonctionnement des mémoires PCM classiques est basé sur la transition de phase du matériau chalcogénure, induite par l'échauffement de ce matériau sous l'effet d'impulsions électriques spécifiques générées par ses deux électrodes. Cette transition se fait entre une phase cristalline, ordonnée, de faible résistance et thermodynamiquement stable et une phase amorphe, désordonnée, de résistance élevée et thermodynamiquement instable.

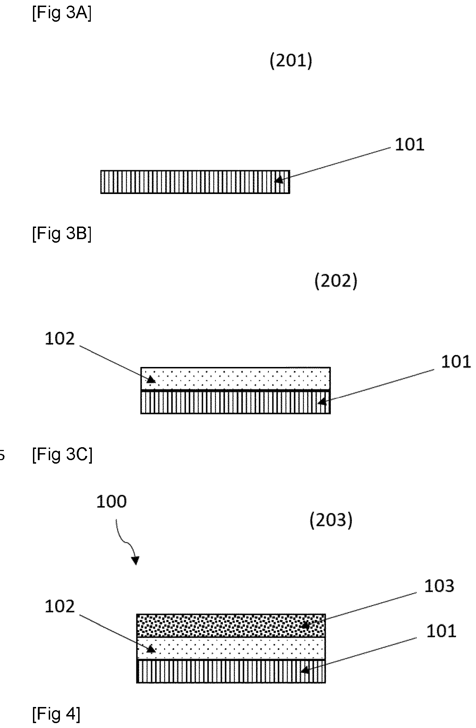

Le fonctionnement d'une mémoire PCM classique est illustré sur la figure 4.

[Fig 4] représente l'intensité circulant dans la couche active d'une mémoire PCM classique, initialement dans son état fortement résistif, en fonction de la tension appliquée aux bornes de ses électrodes.

On constate que, pour des tensions inférieures à une tension représentée en pointillés, l'intensité circulant dans la couche active de la mémoire PCM classique varie peu à mesure que la tension aux bornes des électrodes augmente. En effet, la mémoire PCM étant dans son état amorphe, elle est faiblement conductrice.

A la tension représentée en pointillés appelée tension seuil, le matériau actif est porté à sa température de fusion. La fusion du matériau actif dans son état amorphe est nécessaire pour réaliser par la suite une recristallisation permettant d'aboutir à l'état cristallin faiblement résistif. Un changement d'état entre un état solide peu conducteur et un état très conducteur, appelé claquage ou « switching », a donc lieu, ce qui se caractérise sur la courbe par des changements brutaux de variations au niveau de la tension seuil.

Au-delà de cette tension seuil, le matériau actif dans un état liquide est plus conducteur, ce qui explique que l'intensité augmente de manière importante en fonction de la tension.

Pour atteindre les performances en termes de temps de programmation et d'endurance demandées pour les mémoires SCM, différents matériaux actifs ont été proposés dans la littérature et notamment du Ge₂Sb₂Te₅ enrichi en antimoine Sb d'un pourcentage compris entre 10 et 40%, l'ajout d'antimoine Sb ayant pour effet d'augmenter la vitesse de cristallisation.

Cependant, de tels matériaux actifs sont sujets à un phénomène de ségrégation entraînant une perte de stabilité du matériau actif sous l'effet de la cristallisation.

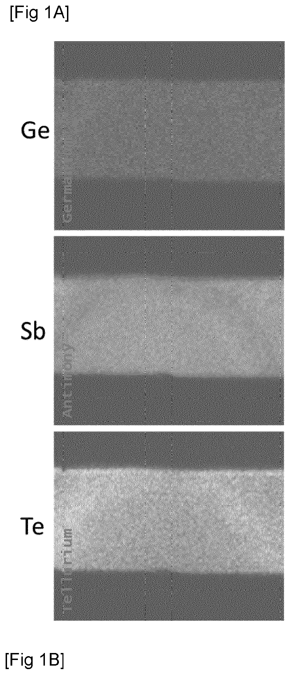

Ce phénomène de ségrégation est illustré sur la figure 1A.

[Fig 1A] montre trois images obtenues par microscopie électronique en transmission représentant respectivement la concentration en germanium Ge, en antimoine Sb et en tellure Te de la couche active d'une mémoire PCM classique réalisée dans un tel matériau actif, après un cycle de programmation. Plus l'intensité en un point de l'image est importante, plus la concentration du composant en ce point est importante.

Pour chaque composant sur la figure 1A est visible un demi-anneau correspondant à une zone enrichie ou appauvrie. Par exemple, on constate que, dans cette zone, la concentration d'antimoine Sb est inférieure à la concentration dans le reste de la couche active alors que la concentration en tellure Te est supérieure à la concentration dans le reste de la couche active.

Ce phénomène s'explique par la recherche de stabilité des composants, qui, soumis à une impulsion électrique, voient leur température et donc leur énergie augmenter, leur permettant de migrer pour établir des liaisons chimiques leur assurant un état énergétiquement plus stable. Ainsi, au fur et à mesure des cycles de programmation, le phénomène de ségrégation s'intensifie pour entraîner une perte de stabilité du matériau actif.

Il existe donc un besoin de développer une mémoire PCM stable sous l'effet d'une impulsion électrique et susceptible de répondre aux spécifications des mémoires SCM.

US 2009/286037 A1 divulgue une cellule mémoire PCM comportant une couche active réalisée dans un ternaire composé de GeSbTe comportant entre 60 et 66% de Sb qui peut être réalisée par pulvérisation cathodique utilisant une cible composée de GST souhaité, trois cibles élémentaires, ou éventuellement deux cibles de GeSb et Te.

US 2007/034849 A1, Z. Wu et al, APPLIED PHYSICS LETTERS 99, 143505 (2011), et B-K Cheong et al, EUROPEAN PHASE CHANGE AND OVONIC SYMPOSIUM E*PCOS 2007, ZERMATT divulguent des mémoires PCM semblables fabriquées par pulvérisation cathodique. Par exemple, trois cibles de pulvérisation (GST-225, Ge, Sb) ont été utilisées pour déposer une couche en Ge₁₈Sb₃₇Te₄₅ dans D2.

### RESUME DE L'INVENTION

L'invention offre une solution aux problèmes évoqués précédemment, en proposant un procédé de fabrication d'une mémoire PCM stable avec un temps de programmation faible et une grande endurance.

Un premier aspect de l'invention concerne un procédé de fabrication d'une mémoire résistive à changement de phase comportant :
- une électrode supérieure ;
- une électrode inférieure ;
- une couche réalisée dans un matériau actif, dite couche active ;
la mémoire passant d'un état fortement résistif à un état faiblement résistif par application d'une tension entre l'électrode supérieure et l'électrode inférieure et étant caractérisée en ce que le matériau de la couche active est un ternaire composé de germanium Ge, de tellure Te et d'antimoine Sb, le ternaire comportant entre 60 et 66% d'antimoine Sb, selon la revendication 1.

Grâce à l'invention, la mémoire PCM réalisée n'est pas soumise au phénomène de ségrégation : elle est donc stable et répond aux exigences en termes d'endurance. De plus, dans l'état fortement résistif, le matériau de sa couche active n'est pas dans un état amorphe mais dans un état polycristallin comportant des noyaux cristallins. De ce fait, pour passer d'un état résistif à l'autre et ainsi programmer la mémoire PCM, il suffit de faire croître/décroître les cristaux en appliquant une tension donnée inférieure à la tension seuil qui est nécessaire pour passer d'un état amorphe à un état cristallin dans une mémoire PCM classique. Ceci permet donc de diminuer le temps de programmation, le stress électrique et le stress thermique, car il n'y a pas de passage entre un état complètement amorphe et un état cristallin, ainsi que le stress mécanique, car il y a moins de changement de densité et de volume, et d'éviter la dérive au cours du temps de l'état fortement résistif vers des états résistifs plus importants.

Outre les caractéristiques qui viennent d'être évoquées dans le paragraphe précédent, la mémoire réalisée selon le premier aspect de l'invention peut présenter une ou plusieurs caractéristiques complémentaires parmi les suivantes, considérées individuellement ou selon toutes les combinaisons techniquement possibles.

Selon un exemple de réalisation, le ternaire comporte entre 7 et 13% de germanium Ge et entre 27 et 33% de tellure Te.

Selon un exemple de réalisation compatible avec l'exemple de réalisation précédent, le ternaire comporte 10% de germanium Ge, 27% de tellure Te et 63% d'antimoine Sb.

Selon un mode de réalisation compatible avec les exemples de réalisation précédent, la couche active est dopée.

Selon l'invention, l'étape de pulvérisation cathodique utilise deux cibles de pulvérisation : une cible composée de l'élément de formule chimique Ge₂Sb₂Te₅ et une cible composée d'antimoine Sb.

La cible composée de l'élément de formule chimique Ge₂Sb₂Te₅ étant stable, son utilisation permet d'éviter la formation d'agrégats. De plus, cette cible étant disponible sur catalogue, son coût est moindre.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1A montre trois images obtenues par microscopie électronique en transmission représentant respectivement la concentration en germanium Ge, en antimoine Sb et en tellure Te de la couche active d'une mémoire PCM ayant une composition selon l'art antérieur, après un cycle de programmation.
- La figure 1B montre trois images obtenues par microscopie électronique en transmission représentant respectivement la concentration en germanium Ge, en antimoine Sb et en tellure Te de la couche active d'une mémoire PCM réalisée selon l'invention, après un cycle de programmation.
- La figure 2 montre le schéma synoptique d'un procédé de fabrication selon l'invention.
- La figure 3A montre la représentation schématique d'une première étape du procédé selon l'invention.
- La figure 3B montre la représentation schématique d'une deuxième étape du procédé selon l'invention.
- La figure 3C montre la représentation schématique d'une troisième étape du procédé selon l'invention.
- La figure 4 représente l'intensité circulant dans la couche active d'une mémoire réalisée selon l'invention et dans la couche active d'une mémoire PCM classique, en fonction de la tension appliquée aux bornes de leurs électrodes, les mémoires se trouvant initialement dans leur état fortement résistif.
- La figure 5 montre une image obtenue par analyse de nano-diffraction ou « nano beam diffraction » sur le matériau de la couche active d'une mémoire réalisée selon l'invention.

### DESCRIPTION DETAILLEE D'AU MOINS UN MODE DE REALISATION DE L'INVENTION

Sauf précision contraire, un même élément apparaissant sur des figures différentes présente une référence unique.

La figure 1A a déjà été décrite en référence à l'état de la technique.

Un premier aspect de l'invention concerne 2. un procédé de fabrication d'une mémoire résistive à changement de phase ou mémoire PCM pour « Phase-Change Memory ».

[Fig 3C] montre une représentation schématique de la mémoire PCM 100 réalisée selon l'invention.

La mémoire PCM 100 comporte :
- une électrode inférieure 101 ;
- une couche active 102 ; et
- une électrode supérieure 103.

On définit une électrode supérieure d'un dispositif comme l'électrode située au-dessus de ce dispositif et l'électrode inférieure d'un dispositif comme l'électrode située en dessous de ce dispositif, les électrodes étant situées de part et d'autre du dispositif. Bien entendu, les adjectifs « supérieure » et « inférieure » sont ici relatifs à l'orientation de l'ensemble incluant l'électrode supérieure, le dispositif et l'électrode inférieure si bien qu'en retournant cet ensemble, l'électrode précédemment qualifiée de supérieure devient l'électrode inférieure et l'électrode précédemment qualifiée d'inférieure devient l'électrode supérieure.

Les électrodes inférieure 101 et supérieure 103 sont réalisées chacune dans un matériau conducteur qui peut être différent ou le même pour les deux électrodes 101,103. Un tel matériau conducteur est par exemple du TiN, TaN, W, TiWN, TiSiN ou encore du WN.

La couche active 102 est une couche de matériau actif réalisée en un ternaire composé de germanium Ge, de tellure Te et d'antimoine Sb. Le pourcentage d'antimoine Sb contenu dans le matériau actif est compris entre 60 et 66%, c'est-à-dire que le matériau actif est composé de 60 à 66% d'antimoine Sb et de 34 à 40% de germanium Ge et de tellure Te.

Par exemple, les 34 à 40% de germanium Ge et de tellure Te se répartissent en 7 à 13% de germanium Ge et 27 à 33% de tellure Te.

Selon un exemple de réalisation préféré, le matériau actif est composé de 10% de germanium Ge, de 27% de tellure Te et de 63% d'antimoine Sb.

Selon un mode de réalisation, la couche active 102 est dopée. La couche active 102 est par exemple dopée avec du carbone C ou de l'azote N.

[Fig 1B] montre trois images obtenues par microscopie électronique en transmission représentant respectivement la concentration en germanium Ge, en antimoine Sb et en tellure Te de la couche active de la mémoire PCM 100 après un cycle de programmation. Plus l'intensité en un point de l'image est importante, plus la concentration du composant en ce point est importante.

On constate l'absence du demi-anneau pour les trois composants et donc l'absence du phénomène de ségrégation.

Ceci est très surprenant compte tenu du fait que dans l'état de la technique, le phénomène de ségrégation s'intensifie à mesure que l'on ajoute de l'antimoine Sb dans la composition du matériau actif.

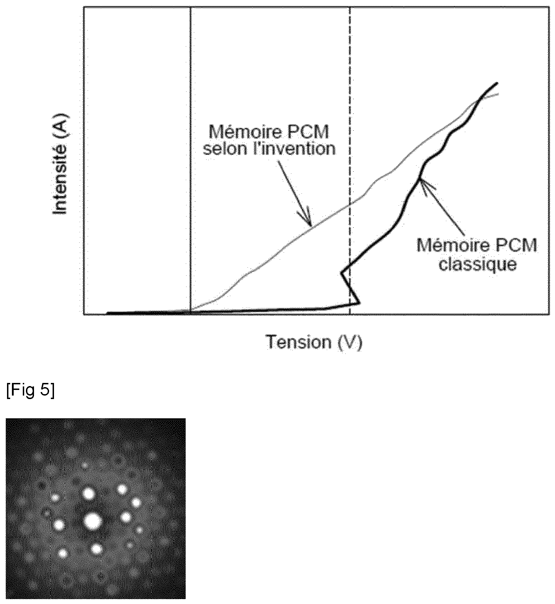

En plus de l'absence du phénomène de ségrégation, la composition de la couche active 102 de la mémoire PCM 100 se caractérise par une phase polycristalline et non pas par une phase amorphe dans l'état fortement résistif, et par une phase monocristalline dans l'état faiblement résistif. Plus particulièrement, dans l'état fortement résistif, la couche active 102 présente des noyaux cristallins visible sur la figure 5.

[Fig 5] est une image obtenue par analyse de nano-diffraction sur le matériau de la couche active de la mémoire PCM 100 montrant des noyaux cristallins représentés par des points blancs lumineux sur l'image.

Ainsi, le passage de l'état faiblement résistif à l'état fortement résistif ne se caractérise pas par un changement d'état, de densité et de volume nécessitant l'application d'une tension seuil mais par une croissance/décroissance de cristaux nécessitant l'application d'une tension inférieure à la tension seuil.

La figure 4 représente l'intensité circulant dans la couche active de la mémoire PCM 100 en fonction de la tension appliquée aux bornes de ses électrodes en plus de l'intensité circulant dans la couche active d'une mémoire PCM classique telle que décrit en référence à l'état de la technique.

On constate que l'intensité augmente linéairement avec la tension aux bornes des électrodes dès qu'on a passé une tension représentée par un trait plein, inférieure à la tension de seuil représenté en pointillés.

La composition de la couche active 102 de la mémoire PCM 100 permet donc de diminuer le stress électrique et le stress thermique dû au passage d'un état complètement amorphe à un état cristallin et de diminuer le stress mécanique puisqu'il y a moins de modification de densité et de volume et le fait d'avoir des noyaux cristallins plutôt qu'une phase amorphe dans l'état fortement résistif permet d'éviter la dérive vers des états résistifs plus importants au cours du temps.

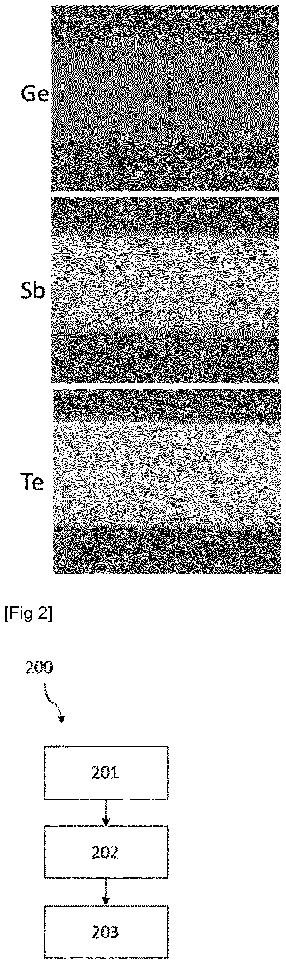

[Fig 2] montre un schéma synoptique des étapes 201 à 203 du procédé 200 de fabrication de la mémoire résistive 100.

[Fig 3A] illustre une première étape 201 du procédé 200 de fabrication de la mémoire résistive 100.

La première étape 201 consiste à réaliser un dépôt conforme d'une couche de matériau conducteur d'électrode inférieure 101 sur un substrat non représenté sur la figure 3A.

On entend par « dépôt conforme d'une couche de matériau sur un substrat » que le matériau est déposé de manière uniforme sur l'ensemble de la surface du substrat.

Le substrat peut être constitué d'une ou de plusieurs couches : il comprend, par exemple, une couche avec des lignes en cuivre exposées permettant d'établir des contacts métalliques avec une couche métallique supérieure et comprend ainsi toute la logique nécessaire pour permettre la connexion avec les lignes des couches supérieures.

[Fig 3B] illustre une deuxième étape 202 du procédé 200 de fabrication de la mémoire résistive 100.

La deuxième étape 202 consiste à utiliser la technique de pulvérisation cathodique pour former la couche active 102 de la mémoire résistive 100.

Le principe de la pulvérisation cathodique est d'utiliser l'énergie d'un plasma à la surface d'une ou de plusieurs cibles de pulvérisation, pour arracher un à un les atomes du matériau de la ou des cible(s) et les déposer sur un substrat.

Selon l'invention, l'étape 202 de pulvérisation cathodique utilise deux cibles de pulvérisation : une cible composée de l'élément de formule chimique Ge₂Sb₂Te₅ et une cible composée d'antimoine Sb. L'étape 202 de pulvérisation cathodique consiste alors à co-pulvériser les deux cibles pour obtenir les pourcentages souhaités pour chaque composant du ternaire.

La pulvérisation ou la co-pulvérisation est par exemple réalisée directement sur la couche de matériau conducteur d'électrode inférieure 101, comme représentée sur la figure 3B.

La figure 3C illustre une troisième étape 203 du procédé 200 de fabrication de la mémoire résistive 100.

La troisième étape 203 consiste à réaliser un dépôt conforme d'une couche de matériau conducteur d'électrode supérieure 103.

Le dépôt conforme est par exemple réalisé directement sur la couche active 102, comme représentée sur la figure 3C.

Le procédé 200 de fabrication illustré sur les figures 3A, 3B et 3C permet de fabriquer une mémoire PCM 100 de forme planaire mais la mémoire PCM 100 pourrait présenter une forme différente. Par exemple, la couche de matériau conducteur d'électrode inférieure 101 comporte deux branches agencées de manière à présenter une forme en « L », la couche active 102 étant en contact avec l'extrémité de la branche de plus grande longueur. Le procédé de fabrication d'une telle mémoire PCM 100 est alors différent du procédé de fabrication 200.

Le procédé 200 de fabrication illustré sur les figures 3A, 3B et 3C permet de fabriquer uniquement la mémoire PCM 100 mais celle-ci pourrait également être fabriquée pour être co-intégrée, par exemple avec un dispositif sélecteur.

## Revendications

1. Procédé (200) de fabrication d'une mémoire (100) résistive à changement de phase comportant :
- une électrode supérieure (103) ;
- une électrode inférieure (101) ;
- une couche réalisée dans un matériau actif, dite couche active (102) ;
la mémoire (100) passant d'un état fortement résistif à un état faiblement résistif par application d'une tension entre l'électrode supérieure (103) et l'électrode inférieure (101), le matériau de la couche active (102) étant un ternaire composé de germanium Ge, de tellure Te et d'antimoine Sb, le ternaire comportant entre 60 et 66% d'antimoine Sb, le procédé comportant les étapes réalisées dans l'ordre suivant :
- une étape (201) de dépôt conforme d'une couche de matériau conducteur d'électrode inférieure (101) sur un substrat ;
- une étape (202) de pulvérisation cathodique pour former la couche active (102) ;
- une étape (203) de dépôt conforme d'une couche de matériau conducteur d'électrode supérieure (103) ;
**caractérisé par** l'utilisation de deux cibles lors de l'étape de pulvérisation cathodique, une cible composée de l'élément de formule chimique Ge₂Sb₂Te₅ et une cible composée d'antimoine Sb.

2. Procédé (200) selon la revendication 1, **caractérisée en ce que** le ternaire comporte entre 7 et 13% de germanium Ge et entre 27 et 33% de tellure Te.

3. Procédé (200) selon l'une quelconque des revendications 1 à 2, **caractérisée en ce que** le ternaire comporte 10% de germanium Ge, 27% de tellure Te et 63% d'antimoine Sb.

4. Procédé (200) selon l'une quelconque des revendications précédentes, **caractérisée en ce que** la couche active (102) est dopée.

## Patentansprüche

1. Verfahren (200) zur Herstellung eines resistiven Phasenwechselspeichers (100), der aufweist:
- eine obere Elektrode (103);
- eine untere Elektrode (101);
- eine Schicht, die aus einem aktiven Material hergestellt ist, bezeichnet als aktive Schicht (102);
wobei der Speicher (100) durch Anlegen einer Spannung zwischen der oberen Elektrode (103) und der unteren Elektrode (101) aus einem stark resistiven Zustand in einen schwach resistiven Zustand wechselt, wobei das Material der aktiven Schicht (102) ein Ternär, zusammengesetzt aus Germanium Ge, Tellur Te und Antimon Sb ist, wobei das Ternär zwischen 60 und 66 % Antimon Sb aufweist, wobei das Verfahren die Schritte aufweist, die in der folgenden Reihenfolge durchgeführt werden:
- einen Schritt (201) des konformen Aufbringens einer leitenden Materialschicht der unteren Elektrode (101) auf ein Substrat;
- einen Schritt (202) des Sputterns, um die aktive Schicht (102) zu bilden;
- einen Schritt (203) des konformen Aufbringens einer leitenden Materialschicht der oberen Elektrode (103);
**gekennzeichnet durch** die Verwendung von zwei Targets beim Schritt des Sputterns, eines Targets, das aus dem Element mit der chemischen Formel Ge₂Sb₂Te₅ zusammengesetzt ist, und eines Targets, das aus Antimon Sb zusammengesetzt ist.

2. Verfahren (200) nach Anspruch 1, **dadurch gekennzeichnet, dass** das Ternär zwischen 7 und 13 % Germanium Ge und zwischen 27 und 33 % Tellur Te aufweist.

3. Verfahren (200) nach einem der Ansprüche 1 bis 2, **dadurch gekennzeichnet, dass** das Ternär 10 % Germanium Ge, 27 % Tellur Te und 63 % Antimon Sb aufweist.

4. Verfahren (200) nach einem der vorangehenden Ansprüche, **dadurch gekennzeichnet, dass** die aktive Schicht (102) dotiert ist.

## Claims

1. A method (200) for manufacturing a phase-change resistive memory (100) including:
- an upper electrode (103);
- a lower electrode (101);
- a layer made of an active material, called an active layer (102);
the memory (100) switching from a high resistivity state to a low resistivity state by applying a voltage between the upper electrode (103) and the lower electrode (101), the material of the active layer (102) being a ternary composed of germanium Ge, tellurium Te and antimony Sb, the ternary including between 60 and 66% of antimony Sb, the method including the steps performed in the following order:
- a step (201) of conformably depositing a conducting material layer of lower electrode (101) onto a substrate;
- a step (202) of sputtering to form the active layer (102);
- a step (203) of conformably depositing a conducting material layer of upper electrode (103);
**characterized by** the use of two sputtering targets during the step of sputtering, a target composed of the element of the chemical formula Ge₂Sb₂Te₅ and a target composed of antimony Sb;

2. The method (200) according to claim 1, **characterised in that** the ternary includes between 7 and 13% of germanium Ge and between 27 and 33% of tellurium Te.

3. The method (200) according to any of claims 1 to 2, **characterised in that** the ternary includes 10% of germanium Ge, 27% of tellurium Te and 63% of antimony Sb.

4. The method (200) according to any of the preceding claims, **characterised in that** the active layer (102) is doped.
